Europäisches Patentamt

European Patent Office

Office européen des brevets

(11) Publication number: **0 147 247**
A2

# EUROPEAN PATENT APPLICATION

(21) Application number: 84401226.0

(22) Date of filing: 14.06.84

(51) Int. Cl.⁴: **H 01 L 21/90**
**H 01 L 23/52**

(30) Priority: 22.12.83 US 564819

(43) Date of publication of application:
03.07.85 Bulletin 85/27

(84) Designated Contracting States:
DE FR GB NL

(71) Applicant: Monolithic Memories, Inc.
2175 Mission College Blvd.
Santa Clara, CA 95050(US)

(72) Inventor: Smith, Jack D.
3787 Norcliffe Court
San Jose, CA 95136(US)

(74) Representative: Martin, Jean-Jacques et al,
Cabinet REGIMBEAU 26, Avenue Kléber
F-75116 Paris(FR)

(54) Method for forming hillock suppression layer in dual metal layer processing and structure formed thereby.

(57) A method is provided whereby a thin stop layer (15) of a passive metal is applied uniformly over first layer metallization (12). The thin stop layer serves as a mechanical stop against the formation of hillocks between the upper surface of the first layer metal line and overlying metal lines (13). Hillocks are thus not formed on the upper surface of the first layer metal and do not punch through the overlying dielectric regions (11) to contact second layer metallization. An additional advantage of the uniform application of the thin hillock suppression layer on the first layer metal is that an effective barrier layer is provided against the diffusion of contaminants. Furthermore, this method provides the ability to recover the wafers if an error in processing occurs after deposition and processing of the second layer of metallization.

FIG. 3

0147247

# METHOD FOR FORMING
## HILLOCK SUPPRESSION LAYER IN
## DUAL METAL LAYER PROCESSING AND
## STRUCTURE FORMED THEREBY

## BACKGROUND OF THE INVENTION

This invention relates to a method for eliminating the formation of hillocks in a dual metal layer processing sequence and the structure formed thereby and, more particularly, relates to the application of a passive metal layer on first layer metal in a dual metal layer structure to mechanically stop hillocks from punching up from the first layer into the second layer metal.

In the fabrication of semiconductor devices, a large number of specific process steps are performed in sequence upon a starting wafer of a single semiconductor crystal, typically silicon. As these process steps are carried out, a detailed network of electrically-altered regions in the semiconductor substrate is overlayed with multiple layers of conductive and insulating regions. The overall structure becomes progressively more complex as one nears the end of the processing sequence. Once the electrically significant regions are fully formed, a layer of passivating material such as silicon oxide or silicon nitride is placed over the surface of the wafer, thereby sealing the devices contained in the wafer, the wafer is scribed and the individual devices are packaged. Every electrically significant region in each packaged device must have electrical integrity in order to permit the circuit incorporated in the device to function as designed.

One known failure mechanism which defeats the integrity of electrically significant regions in semiconductor devices is the shorting of conductive lines to the substrate, to other conductive lines or to regions from which they are designed to be electrically isolated. One physical basis for this failure mechanism is the formation of hillocks, which are protuberances extending away from the surfaces of metal layers and punching through insulating regions which are intended to isolate the metal layers from the substrate, from other metal lines, or from other electrically significant regions. Hillocks are believed to be stress relief regions which occur in metal layers principally due to processing at elevated temperatures after the metal layers have been formed. Metal layers are typically formed at temperatures on the order of 350°C; subsequent processing may reach temperatures of 450°C. It has been found that aluminum lines, commonly used as conductive paths in integrated circuits, are subject to hillock formation if they experience temperatures above 150°C. One technique to avoid the formation of hillocks has been to conduct subsequent process steps at temperatures lower than critical hillock-formation temperatures, i.e., at temperatures less than 150°C. A deficiency with this approach is that subsequent deposition steps such as the application of layers of silicon dioxide and silicon nitride are not performed optimally at low temperatures. For example, silicon dioxide layers formed at such low temperatures will be nonuniform, which in turn may lead to a failure in the silicon dioxide layers insulating ability. See, for example, W. R. Morcom, et al, "Method of Fabricating Two-Level Interconnects and Fuse on an IC", U.S. Patent No. 4,184,933, which are hereby incorporated by reference. Such an approach also requires expensive low temperature processing equipment.

Another approach to the elimination of hillocks is to alloy metal layers with materials which will prevent hillock formation. It is believed that hillocks are formed by the migration of vacancies. Alloys serve to introduce impurities which impede the movement of vacancies and therefore reduce the formation of hillocks. See, e.g., P. Chauhari, et al, "Method of Inhibiting Hillock Formation in Films and Film Thereby, and Multilayer Structure Therewith", U.S. Patent No. 4,012,756, which are hereby incorporated by reference. A further approach has been to chemically bind the metal atoms in metal lines without appreciably reducing the conductivity of the layers. For example, aluminum layers have been interspersed with Al-O films. The oxygen is believed to bind the aluminum in a way to prevent its gross redistribution even if lateral stress is experienced. See, e.g., T. J. Faith, "Hillock-Free Integrated-Circuit Metallizations by Al/Al-O Layering", J. Appl. Phys. 52(7) July 1981, p.4630, which is hereby incorporated by reference. This approach does, in fact, reduce the conductivity of metal lines. However, it is far too complicated a process for commercial semiconductor fabrication.

As the density of device fabrication progresses to the very large scale integration (VLSI) level, it has become essential to prevent the formation of hillocks. Not only are conductive lines narrower, but there are more of them and they are situated much closer to electrically significant regions from which they must be electrically isolated. In addition, at the VLSI level, multiple conductive lines have become commonplace so that hillocks may be formed between vertically spaced apart metal lines. A method for forming structures with multiple layers of metallization is required which does not lead to the formation of hillocks.

BRIEF DESCRIPTION OF THE DRAWINGS

For a more complete understanding of the method of the present invention, reference may be had to the accompanying drawings which are incorporated herein by reference and in which:

Figure 1 is a plan view of a first and second metal layer line arrangement in a section of an integrated circuit;

Figure 2 is a cross section of the crossover of a second layer metal line over first layer metal line as it would appear in dual layer metal schemes of the prior art;

Figure 3 is a cross section of a crossover of a second layer metal line over a first layer metal line in accordance with the structure of the present invention taken through line 3-3 of Figure 1; ·

Figure 4 is a cross-sectional view of an interconnection between second layer metal and first layer metal in accordance with the structure of the present invention as formed by the method of the present invention;

Figure 5 is a cross sectional view of a prior art interconnection between second layer metal and first layer metal through a via in the intervening dielectric isolation;

Figure 6 shows reworking as performed using prior art techniques; and

Figure 7 shows reworking as taught by this invention.

SUMMARY

A method and structure are provided whereby a thin stop layer of a passive metal is applied uniformly over first layer metallization. The thin stop layer serves as a mechanical stop against the formation of hillocks between the upper surface of the first layer metal line and overlying metal lines. Hillocks are thus not formed on the upper surface of the first layer metal and do not punch through the overlying dialectric regions to contact second layer metallization. An additional advantage of the uniform application of the thin hillock suppression layer first layer metal is that an effective barrier layer is provided against the diffusion of contaminants.

DETAILED DESCRIPTION

The method of the present invention involves the application of a thin layer of a passive metal over a conductive metal layer to serve as a mechanical stop against the punch-through of hillocks from the first layer through the overlying dielectric to make contact with overlyig layers of metallization. As far as is known, no metallurgical or chemical suppression occurs; the mechanism simply is the mechanical resistance to punch through, i.e. the stop layer function. Passive metals suitable for use as such a stop layer are well known in the semiconductor industry and include such metals as titanium-tungsten, platinum, nickel-chromium, gold, silver, and various silicides such as platinum silicide, tungsten silicide, and the like. The requisite properties for metals to be added to this class are that they not introduce undesired impurities into the system and are not themselves subject to electromigration or hillock formation. As a consequence of the utilization of the method of the present invention, there are no constraints impressed upon subsequent processing steps. Heat treatments up to temperatures as high as 500°C may be tolerated without the formation of hillocks since the mechanical stop function of the hillock suppression layer distributes hillock punch-through forces experienced at particular points over wider areas so that there is no penetration through the stop layer into the overlying dielectric layer.

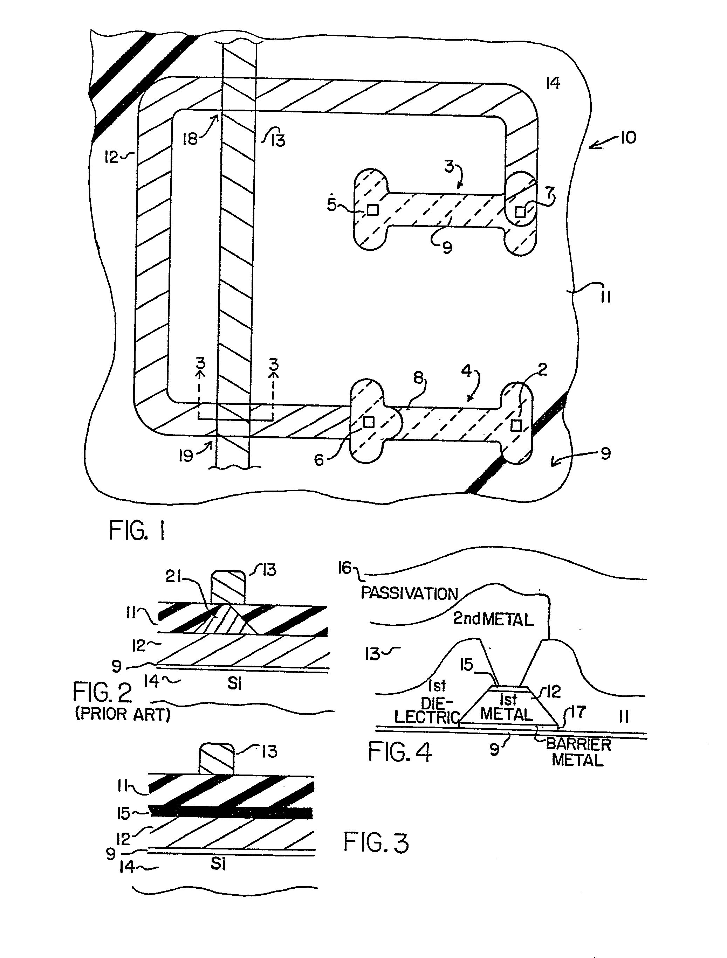

The utility of the structure produced by the method of the present invention is shown in Figures 1 through 3. In Figure 1 a plan view is provided of an isolated sector on an integrated circuit chip. Two wishbone resistors 3 and 4 are shown to be interconnected by means of a metal line 12 formed as part of a first layer of metal. Each resistor is formed in the silicon substrate as a diffused or ion implanted region. The two resistances, respectively, are the net resistances in the substrate between ohmic contacts 5 and 7 and between ohmic contacts 6 and 2. The enlarged ends of the wishbone structures allow satisfactory electrical contacts to be made at the ends. These contacts are made either directly to the doped regions making up the wishbone resistors 3 and 4 or are made through via holes in the lowermost insulating layers. As shown, wishbone resistor 3 is connected electrically in series with wishbone resistor 4. Electrical interconnection is established by means of a via 7 which has been opened in the lowermost overlying layer of silicon dioxide 11 to one end of wishbone resistor 3 and a via 6 which has been opened through the lowermost layer of silicon dioxide to one end of wishbone resistor 4. Since these vias are open before first layer metal 12 is applied, the interconnecting metal line 12 drops down through the via and makes electrical contact with the respective wishbone resistors 3 and 4. What is desired is that low resistance electrical connection be established between the two ends of the two wishbone resistors 3, 4 without electrical connection being made with other parts of the circuit and without excessive capacitive coupling to other regions in the circuit. In the sector 10 shown in Figure 1, a blanket layer 9 of silicon dioxide covers the surface of the underlying silicon substrate 14. This may be seen in Figure 2 in the thick hatched lines shown for silicon oxide layer 9. The purpose of this silicon dioxide layer 9 is to protect the surface of the underlying substrate and to provide an insulating layer between first layer metal 12 and the underlying substrate 14 except where vias are used to open up the oxide layer. A second silicon oxide layer 11 between first layer metal 12 and second layer metal 13 is provided to prevent electrical connection between the two metal layers.

As seen in Figs. 2 and 3, the critical locations where hillocks can cause interlayer shorting are found where second layer metal line 13 crosses over first layer metal 12. These critical crossover areas are shown in Figure 1 as regions 18 and 19. It is at these crossovers that a hillock 21, shown in cross-sectional view of the the prior art shown in Figure 2, could penetrate the silicon dioxide insulating layer 11 and reach the bottom of second layer metal line 13 and thereby producing an electrical short. Hillocks which penetrate the silicon dioxide at other regions may not harm the operation of the device, unless they penetrate oxide 9 and provide a short circuit to substrate 14. Due to the more sensitive nature of metal crossovers, it is at the metal crossovers that the method of the present invention achieves its most useful result. As seen in the cross-sectional view of Figure 3, the inclusion of passive metal layer 15 between first layer metal 12 and overlying silicon dioxide insulating layer 11 prevents the punch-through of a hillock anywhere that the layer 15 exists. Typically, the first layer metal 12 will have a thickness of approximately 6000Å and passive metal layer 15 will have a much smaller thickness on the order of 600Å.

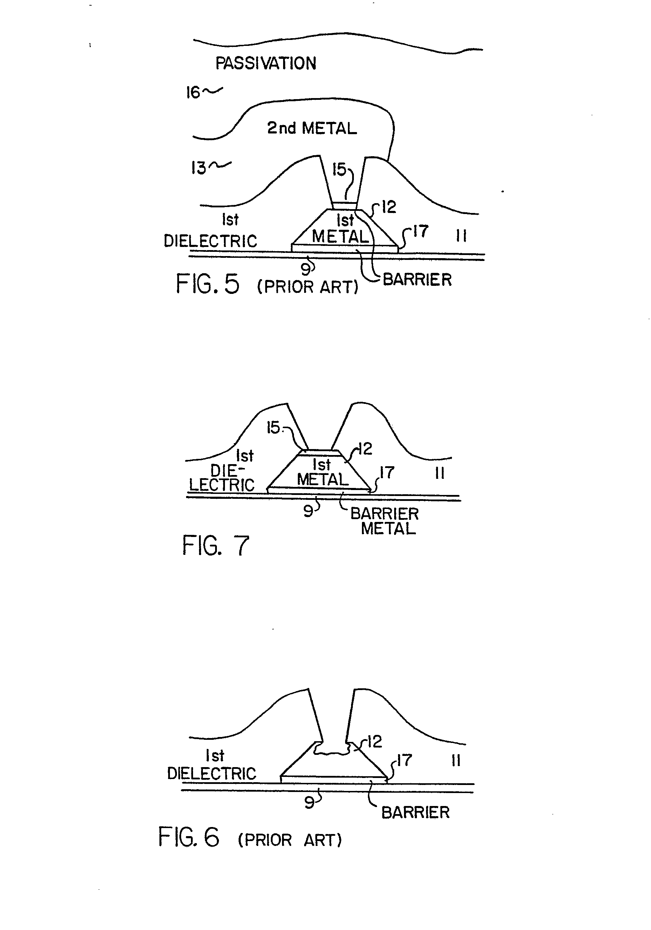

In a preferred embodiment of the present invention in which it is desired to make electrical contact in selected areas between segments of the second layer metal and the first layer metal, the hillock suppression layer 15 is formed just after the formation of the first metalization layer 11, and is etched coextensive with first layer of metallization 11 as shown in Figure 5 so that it is left in the region in between the second layer metal 13 and the first layer metal 12 on the top of the first layer of metal 12 prior to the deposition of the dielectric 11. The second layer metal 13 is then deposited through the vias onto the exposed portion of the barrier metal 15. If and error occurs in the processing of the second layer of metal 13, the second layer of metal can be removed by etching (for example, with a solution of acetic, nitric, and hydroflouric acids when the second metal layer is aluminum or an alloy of aluminum) without attacking the first layer of metal 12 due to the presence of the barrier metal 15, as is shown in Figure 7.

In start contrast, in prior art structures as shown in the cross-sectional view of Figure 5 the barrier hillock suppression layer 15 is formed just prior to the formation of the second layer of metallization 13. Thus, in the prior art, such hillock suppression layers were formed coextensive with the second layer of metal 13. Accordingly, the removal of the second metal layer 13 (for example, should an error occur when forming second metallization layer 13) results in the etchant used to remove the second layer of metal 13 to leak past the barrier metal 15 and attack the underlying first layer of metallization 12, as shown in Figure 6. This undesirable effect of prior art process and their resulting structures is most likely to occur in a device in which the second layer of metal and the second layer of metal are made from the same material, i.e., both the first and second metallization layers are formed of aluminum or an alloy thereof, or polycrystalline silicon. Also, in the preferred embodiment, the absence of the barrier metal layer under most of the second layer metal permits the second layer metal to be etched more readily everywhere since the barrier layer does not exist to make it difficult to determine the end point for the etch.

To establish a benchmark comparison, a prior art process for forming dual layer metallization with intervening barrier metal layer, as well as a barrier metal layer between the first layer of metallization and the base insulation layer formed on the substrate, is described below:

1. Deposit first layer barrier metal (600Å) on substrate covered with base insulation layer;

2. Deposit first layer conduction metal (6000Å);

3. Define first layer conduction metal pattern with photoresist mask;

4. Etch first layer conduction metal to form desired pattern;

5. Etch first layer barrier metal to form pattern coextensive with first layer conduction metal;

6. Remove photoresist;

7. Deposit dielectric (300°C);

8. Define dielectric with photoresist mask;

9. Remove selected portions of dielectric;

10. Remove photoresist;

11. Deposit second layer barrier metal (1200Å);

12. Deposit second layer conduction metal (13,000Å);

13. Define second layer conduction metal pattern with photoresist;

14.     Etch second layer conduction metal to form
        desired pattern;

15.     Etch second layer barrier metal to form pattern
        coextensive with second metallization layer;

16.     Remove photoresist.

This prior art process produces a dual layer metallization structure having an intervening barrier metal layer coextensive with the second layer of metallization.

In contrast with the prior art method for forming dual layer metal structures set out above, the method of the present invention inserts a step for forming a hillock suppression layer at a stage of the process where it may be selectively etched to give a barrier layer formed on top of all of the first layer of metallization which thus acts as a hillock suppression layer and also allows reworking a wafer whose second metallization layer has been misprocessed. The process of the present invention is given as follows:

1.      Deposit first layer barrier metal (600Å) on a
        substrate covered with a base insulation layer;

2.      Deposit first layer conduction metal (6000Å);

3.      Deposit hillock suppression layer (600Å);

4.      Define first layer conduction metal with photoresist;

5.      Etch hillock suppression layer to form desired
        pattern;

6.      Etch first layer conduction metal to form
        pattern;

7.    Etch first layer barrier metal to form pattern coextensive with first layer conduction metal;

8.    Remove photoresist;

9.    Deposit dielectric (300°C) - the hillock suppression layer now prevents the formation of any hillocks;

10.    Define dielectric with photoresist mask;

11.    Remove selected portions of dielectric;

12.    Deposit second layer conduction metal;

13.    Define second layer conduction metal with photoresist;

14.    Etch second layer conduction metal to form desired pattern;

15.    Remove photoresist.

The improvement obtained by the method of the present invention is that a hillock suppression layer is selectively formed only where needed above the first layer metal, the hillock suppression layer also serves the function of a barrier metal layer to prevent the diffusion of contaminants. The hillock suppression layer is thus present over the top of all of the first layer of metallization and the etching of the second layer of metallization is improved as end point detection is improved as the barrier metal already has been defined prior to the definition and patterning of the second layer of metallization.

The specific embodiments of this invention described in this specification are intended to serve by way of example and are not a limitation on the scope of my invention.  Numerous other embodiments of this invention will become apparent to those of ordinary skill in the art in light of the teachings of this specification.

## CLAIMS

I claim:

1. A method for forming a dual layer metal structure which incorporates a hillock suppression layer, comprising, providing a silicon substrate, depositing a first layer of conductive metal on said substrate, said method characterized by comprising of the steps of:

applying a hillock suppression layer of a passive metal on said first layer of conduction metal;

defining said hillock suppression layer to a selected pattern;

defining said first layer of conductive metal;

applying a layer of dielectric material over said hillock suppression layer, said first layer conduction metal and said silicon substrate;

depositing a second layer of conductive material; and

defining said second layer of conductive layer to a selected pattern.

2. The method as in Claim 1 further characterized in that said passive metal comprises a material selected from the group of materials consisting of titanium, tungsten, platinum, nickel, chromium, gold, silver and silicon.

3. The method as in Claim 1 further characterized in that said passive metal comprises a material selected

MMIP:2:H

0147247

from the group of materials consisting of titanium silicide, tungsten silicide, and platinum silicide.

4. The method as in Claim 1 further characterized in that said first layer of conductive metal comprises a material selected from the group of materials consisting of aluminum and polycrystalline silicon.

5. The method as in Claim 1 further characterized in that said second layer of conductive metal comprises a material selected from the group of materials consisting of aluminum and polycrystalline silicon.

6. The method as in Claim 1 which is further characterized by including the steps of providing an insulating layer on said silicon substrate and beneath said first layer of conductive metal.

7. The method as in Claim 6 which is further characterized by including the step of providing an additional hillock suppression layer on said dielectric layer.

8. The method as in Claim 6 further characterized in that said insulating material comprises a material selected from the group of materials consisting of oxides of silicon and silicon nitride.

9. The method as in Claim 1 further characterized in that said insulating material comprises a material selected from the group of materials consisting of oxides of silicon and silicon nitride.

10. A semiconductor structure comprising a substrate, a first metal layer, said structure characterized by comprising

a hillock suppression layer coextensive with said first metal layer;

a dielectric layer formed over said hillock suppression layer; and

a second metal layer formed over said dielectric layer.

11.  The structure as in Claim 10 further characterized in that said hillock suppression layer comprises a material selected from the group of materials consisting of titanium, tungsten, platinum, nickel, chromium, gold, silver and silicon.

12.  The structure as in Claim 10 further characterized in that said hillock suppression layer comprises a material selected from the group of materials consisting of titanium silicide, tungsten silicide, and platinum silicide.

13.  The structure as in Claim 10 further characterized in that said first metal layer comprises a material selected from the group of materials consisting of aluminum and polycrystalline silicon.

14.  The structures as in Claim 10 further characterized in that said second metal layer comprises a material selected from the group of materials consisting of aluminum and polycrystalline silicon.

15.  The structure as in Claim 10 further characterized in that said dielectric layer comprises a material selected from the group of materials consisting of oxides of silicon and silicon nitride.

FIG. 1

FIG. 2
(PRIOR ART)

FIG. 4

PASSIVATION

2nd METAL

1st
DIE-
LECTRIC

1st
METAL

BARRIER
METAL

FIG. 3

Si

FIG. 5 (PRIOR ART)

FIG. 7

FIG. 6 (PRIOR ART)